# EUROPÄISCHE PATENTSCHRIFT

(11) **EP 4 436 044 B1**
(45) Veröffentlichungstag und Bekanntmachung des Hinweises auf die Patenterteilung: **09.12.2026**
(21) Anmeldenummer: 23163160.7
(22) Anmeldetag: 21.03.2023
(51) Int. Cl.: H03K 17/97

(54) **ANORDNUNG UMFASSEND EIN FUNKTIONSMODUL UND EIN SCHALTGERÄT SOWIE VERFAHREN ZUR MONTAGE**
ASSEMBLY COMPRISING A FUNCTIONAL MODULE AND A SWITCHING DEVICE, AND METHOD FOR ASSEMBLY
ENSEMBLE COMPRENANT UN MODULE FONCTIONNEL ET UN APPAREIL DE COMMUTATION ET PROCÉDÉ DE MONTAGE

(43) Veröffentlichungstag der Anmeldung: 25.09.2024
(73) Patentinhaber: Insta GmbH, 58509 Lüdenscheid (DE)
(72) Erfinder: Becker-Hennecke, Ralph, 58239 Schwerte (DE)
(74) Vertreter: Fobbe, Tobias

(56) Entgegenhaltungen:
- EP-A1- 4 016 007
- WO-A1-2018/005281
- AT-A4- 525 242
- US-A1- 2014 218 142

## Beschreibung

Die Erfindung betrifft eine Anordnung umfassend ein Funktionsmodul zum Einbau in eine Installationsdose und ein manuell zu betätigendes Schaltgerät der Gebäudeinstallationstechnik, welches Funktionsmodul durch die Betätigung eines an dem Schaltgerät angeschlossenen Betätigungselementes eines Oberteils des Schaltgerätes beeinflussbar ist, wobei das Funktionsmodul zumindest eine Schnittstelle aufweist, mittels welcher zumindest ein Aktor entsprechend einer Betätigung des Betätigungselements ansteuerbar ist, wobei an dem Schaltgerät mindestens ein Magnet angeordnet ist, welcher bei Betätigung des Betätigungselementes seine Position ändert, und dass das Funktionsmodul einen Sensor zur Erfassung des Magnetfeldes aufweist, so dass die Änderung des Magnetfeldes bei Betätigung des Betätigungselementes detektiert wird, wobei das Funktionsmodul eine Auswerteeinheit zur Auswertung der Magnetfeldänderung aufweist, die dazu eingerichtet ist, in Abhängigkeit der sensierten Magnetfeldänderung zu identifizieren, um welche Schaltgeräteart es sich bei dem Schaltgerät handelt, welche Identifikation in die funktionsmodulseitige Ansteuerung des Aktors einfließt.

Die Erfindung betrifft ferner ein Verfahren zur Montage einer solchen Anordnung in einer Installationsdose.

Aus AT 525 242 B1 ist eine gattungsgemäße Anordnung mit einem Funktionsmodul zum Einbau in eine Installationsdose und einem manuell zu betätigenden Schaltgerät der Gebäudeinstallationstechnik bekannt geworden. Ein solches Funktionsmodul ist durch die Betätigung eines an dem Schaltgerät angeschlossenen Betätigungselementes eines Oberteils des Schaltgerätes beeinflussbar, beispielsweise um Lampen zu schalten, zu dimmen oder um Jalousien zu steuern, und zwar auch fernbedienbar, beispielsweise via Endgerät. Hierzu weist das Funktionsmodul zumindest eine Schnittstelle auf, mittels welcher zumindest ein Aktor entsprechend einer Betätigung des Betätigungselements ansteuerbar ist, wobei an dem Schaltgerät mindestens ein Magnet angeordnet ist, welcher bei Betätigung des Betätigungselementes seine Position ändert. Ferner weist das Funktionsmodul einen Sensor zur Erfassung des Magnetfeldes auf, so dass die Änderung des Magnetfeldes bei Betätigung des Betätigungselementes detektiert wird. Es versteht sich, dass das Funktionsmodul über ein Endgerät, insbesondere ein mobiles Endgerät, beeinflussbar ist, um auf komfortable Weise bedient werden zu können. Ein solches, vorbekanntes Funktionsmodul umfasst zudem eine Auswerteeinheit zur Auswertung der Magnetfeldänderung, die dazu eingerichtet ist, in Abhängigkeit der sensierten Magnetfeldänderung zu identifizieren, um welche Schaltgeräteart es sich bei dem Schaltgerät handelt, welche Identifikation in die funktionsmodulseitige Ansteuerung des Aktors einfließt, so dass ein Austausch von Schaltern durch Taster vermieden wird. So erfordert das Dimmen einer Lampe mit einem Funktionsmodul beispielsweise eine spezifische Ansteuerung, je nachdem, ob das zugrundeliegende Schaltgerät ein Taster oder ein Schalter ist. Daher ist die Identifikation der Schaltgeräteart durch die Auswerteeinheit ein weiterer Vorteil eines solchen Funktionsmoduls.

Durch ein solches, vorbekanntes Funktionsmodul kann der Installationsaufwand mit Blick auf den zu leistenden Verkabelungsaufwand wie er bei herkömmlichen Funktionsmodulen ohne Sensierung der Magnetfeldänderung erforderlich ist - hierbei werden Kabel zwischen Schaltgerät und Funktionsmodul (nachfolgend fliegende Verkabelung genannt) angeschlossen, um die Betätigung elektrisch zu übermitteln - signifikant verringert werden, da Funktionsmodul und Schaltgerät magnetisch miteinander kommunizieren; ein elektrischer Anschluss des Funktionsmoduls an das Schaltgerät mithin obsolet geworden ist.

Problematisch bei solchen vorbekannten gattungsgemäßen Funktionsmodulen beziehungsweise Anordnungen ist jedoch, dass diese hinter ein Schaltgerät in die Installationsdose montiert werden, wobei die magnetische Kommunikationsqualität beeinträchtigt wird, wenn Erschütterungen auftreten, da das Funktionsmodul in der Dose durch die Erschütterungen verrutscht. Ein solches Verrutschen - beispielsweise bedingt durch lautes Musikhören, Vibrationen im Gebäude durch umfallende Gegenstände, Erdbeben oder das einfache Betätigen eines benachbarten Schaltgerätes - führt daher zu unerwünschten Fehlbetätigungen des Schaltgerätes, so dass zum Beispiel eine Lampe eingeschaltet wird, obwohl dies nicht beabsichtigt ist, da der Magnetfeldsensor sich bezüglich des Magneten des Schatlgerätes bewegt, obwohl eine Betätigung des Schaltgerätes gerade nicht vorgenommen wurde. Zudem ist problematisch, dass die Funktionsmodule irgendeine beliebige Position innerhalb der Installationsdose einnehmen, so dass das Signal- Rausch-Verhältnis bezüglich der magnetischen Kommunikation zwischen Magnet und Magnetfeldsensor weder standardisiert noch optimiert ist. In der Praxis hat sich zudem gezeigt, dass das Einsetzen des Funktionsmoduls in die Installationsdose und das nachgelagerte Befestigen des Schaltgerätes an der Installationsdose regelmäßig mit einem erhöhten Installationsaufwand einhergeht, da das Funktionsmodul dazu tendiert, trotz Einsetztens beziehungsweise Einlegens in die Installationsdose aufgrund von in der Installationsdose unter mechanischen Spannungen stehenden Kabelguts wieder aus der Installationsdose herausgedrückt zu werden. Damit ist die Installation des Schaltgerätes zusammen mit dem Funktionsmodul verkompliziert.

Darüber hinaus besteht gleichzeitig aufgrund der Unterbringung der Elektronik im Funktionsmodul ein nicht unerheblicher Bauraumbedarf beziehungsweise eine gewisse Aufbauhöhe des Funktionsmoduls. Dieser macht ein Nachrüsten eines Funktionsmoduls zum Einbau in eine flache Installationsdose, beispielsweise mit einer Tiefe von weniger als 40 mm, insbesondere weniger als 32 mm unmöglich. Insofern wird es unerwünschter Weise erforderlich, flache Installationsdosen durch tiefe Installationsdosen auszutauschen, wenn ein gattungsgemäßes Funktionsmodul eingebaut werden soll, beispielsweise um via mobiles Endgerät Lampen oder Jalousien fernzusteuern. Dieser infrastrukturelle Aufwand hält viele eigentlich bezüglich der Installation eines solchen Funktionsmoduls interessierte Anwender davon ab, ein entsprechendes Funktionsmodul zu installieren.

Ausgehend von diesem diskutierten Stand der Technik liegt der Erfindung die Aufgabe zugrunde, eine Anordnung mit einem Funktionsmodul zum Einbau in eine Installationsdose und mit einem manuell zu betätigenden Schaltgerät vorzuschlagen, wobei die vorstehend genannten Nachteile vermieden sind. Insbesondere soll die effektiv beanspruchte Bauraumhöhe verringert, die Zuverlässigkeit der Bedienung gegenüber mechanischen Erschütterungen wirksam verbessert und der Installationsaufwand verringert werden.

Gelöst wird diese Aufgabe durch eine Anordnung, wobei das Funktionsmodul das ein Gehäuse aufweist, welches eine Schnittstelle mit Anschlüssen aufweist, wobei das Gehäuse mindestens eine Ausnehmung aufweist, die mit Vorsprüngen des Schaltgerätes in Eingriff gestellt ist, so dass die effektive Einbautiefe des Funktionsmoduls in der Installationsdose hinter das Schaltgerät verringert und das Funktionsmodul positionsfixiert wird.

Der Kerngedanke der Erfindung besteht darin, dass das Funktionsmodul ein Gehäuse aufweist, welches eine Schnittstelle mit Anschlüssen aufweist. Diese Anschlüsse dienen beispielsweise zum Anschluss an eine Energieversorgung, insbesondere an einen Außenleiter und einen Neutralleiter. Ein weiterer Anschluss dient beispielsweise dazu, eine Steuerleitung an das Funktionsmodul anzuschließen, so dass ein Verfahren einer Jalousie (wobei hier zwei Steuerleitungen erforderlich sind) oder das Dimmen einer Lampe (eine Steuerleitung) ermöglicht wird. Aufgrund des Entfalls der Notwendigkeit einer fliegenden Verkabelung zwischen Funktionsmodul und Schaltgerät sind nicht mehr als vier Anschlüsse, regelmäßig sogar nur drei Anschlüsse, erforderlich. Der hierdurch bezüglich klassischer Funktionsmodule, die ohne eine Änderung des Magnetfeldes bei Betätigung des Betätigungselementes auskommen, sondern elektrisch die Betätigung erfassen, geschaffene Freiheitsgrad, die Anzahl der Anschlüsse von sechs oder sieben auf beispielsweise vier zu begrenzen, erlaubt es, die effektive Einbautiefe des Funktionsmoduls in der Installationsdose hinter dem Schaltgerät signifikant zu verringern. Hierzu weist das Gehäuse mindestens eine Ausnehmung auf, die mit Vorsprüngen des Schaltgerätes in Eingriff gestellt ist. Derartige Vorsprünge des Schaltgerätes sind regelmäßig durch zwei Haltevorrichtungen, insbesondere Schraubdome zur Spreizung von Spreizkrallen zur Festlegung des Schaltgerätes in der Installationsdose, gegeben. Dabei spielt die Erfindung auf geschickte Art und Weise den Freiheitsgrad aus, dass ein Funktionsmodul, das die Änderung des Magnetfeldes bei Betätigung des Betätigungselementes detektiert, lediglich eine Schnittstelle mit beispielsweise maximal vier Anschlüssen, beispielsweise in Gestalt von Schraubklemmen, aufweisen kann. Durch die intelligente erfindungsgemäße Gestaltung des Gehäuses wird der vorstehend beschriebene Freiheitsgrad dahingehend ausgespielt, dass die effektive Einbautiefe des Funktionsmoduls in der Installationsdose hinter dem Schaltgerät insofern verringert wird, als dass das Gehäuse des Funktionsmoduls mindestens eine, regelmäßig zwei Ausnehmung(en) aufweist, die mit Vorsprüngen des Schaltgerätes in Eingriff gestellt ist/sind. Durch eine solche geschickte Gestaltung des Gehäuses wird der aus Funktionsmodulen mit fliegender Verkabelung beziehungsweise elektrischer Detektion der Betätigung bekannte Bauraumverlust gerade vermieden. Dadurch, dass die Ausnehmung vorzugsweise lediglich in dem Bereich der zwei Haltevorrichtungen, insbesondere der Schraubdome zur Spreizung von Spreizkrallen zur Festlegung des Schaltgerätes in der Installationsdose, vorgesehen ist, wird das Volumen des Funktionsmoduls nur unwesentlich verringert, der effektive Bauraumbedarf jedoch entscheidend abgesenkt.

Gleichzeitig wird durch das Funktionsmodul der erfindungsgemäßen Anordnung die Zuverlässigkeit der Bedienung gegenüber mechanischen Erschütterungen wirksam verbessert, indem das erfindungsgemäße Funktionsmodul durch das Vorsehen eines Gehäuses mit mindestens einer Ausnehmung, die mit Vorsprüngen des Schaltgerätes in Eingriff gestellt ist, positionsfixiert wird. Damit wird erfindungsgemäß nicht nur ein unerwünschtes Verrutschen des Funktionsmoduls in Folge von Erschütterungen, beispielsweise durch Betätigung eines benachbarten Schaltgerätes, und damit eine Fehlbetätigung des an das Funktionsmodul angeschlossenen Aktors vermieden, sondern sogar eine bezüglich der Auswertung der sensierten Magnetfeldänderung durch die Auswerteeinheit optimierten und wohldefinierten Vorzugspositionierung des Funktionsmoduls sichergestellt, so dass ein optimales und zuverlässig erreichbares Signal-Rausch-Verhältnis erreicht wird.

Darüber hinaus wird durch das Funktionsmodul der erfindungsgemäßen Anordnung vorteilhafterweise der Installationsaufwand des Funktionsmoduls hinter ein Schaltgerät signifikant verringert, indem das Gehäuse des Funktionsmoduls mindestens eine, regelmäßig zwei Ausnehmung(en) aufweist, die mit Vorsprüngen des Schaltgerätes in Eingriff gestellt ist/sind, so dass das Funktionsmodul der erfindungsgemäßen Anordnung an dem Schaltgerät gelagert angeschlossen ist. Mithin ist ein gemeinsames Einsetzen, also: Funktionsmodul und Schaltgerät zusammen, ermöglicht. Hierdurch wird der Installationsaufwand spürbar abgesenkt, da das Herausfallen gattungsgemäßer Funktionsmodule (beispielsweise da das unter mechanischer Spannung stehende Kabelgut in der Installationsdose eine rückstellende Kraft erzeugt) effektiv vermieden wird, indem das Funktionsmodul der erfindungsgemäßen Anordnung, das mit Vorsprüngen des Schaltgerätes in Eingriff gestellt ist, zusammen in einem Schritt direkt in der Installationsdose festgelegt wird.

Gemäß einer besonders bevorzugten Ausgestaltung der erfindungsgemäßen Anordnung ist die mindestens eine Ausnehmung des Funktionsmoduls mindestens teilweise komplementär zu den Vorsprüngen des Schaltgerätes. Eine solche Ausgestaltung erlaubt es, das Volumen des Funktionsmoduls zu maximieren und den Einbautiefenverlust zu minimieren.

In einer Ausgestaltung, die für den Installateur besonders praktisch handzuhaben ist, weist das Funktionsmodul der erfindungsgemäßen Anordnung abgeflachte Seiten auf.

Gemäß einer besonders bevorzugten Ausgestaltung des Funktionsmoduls der erfindungsgemäßen Anordnung macht die mindestens eine Ausnehmung bezüglich der Grundfläche des Funktionsmoduls in einer Draufsicht weniger als 50 %, insb. weniger als 30 % der Grundfläche aus. Hierdurch wird es durch das Beschränken der Ausnehmung bezüglich der Grundfläche des Funktionsmoduls ermöglicht, dass die Ausnehmungen dezidiert für das vorzugsweise komplementäre Aufnehmen beziehungsweise Ineingriffstellen von Schraubdomen geschaffen sind, so dass nicht viel Volumen des Funktionsmoduls geopfert wird, aber aufgrund des Ineingriffstellens der effektive Bauraumbedarf abgesenkt und die Positionsfixierung des Funktionsmoduls sichergestellt wird.

In einer erfindungsgemäßen Ausgestaltung, die für den Installateur besonders einfach handzuhaben ist, insbesondere in die Installationsdose einzusetzen ist, liegt der Krümmungsradius der Grundfläche des Funktionsmoduls im Bereich von 18 bis 27 mm.

In einer erfindungsgemäßen Ausgestaltung, die sich durch eine für viele Installationsdosen geeignete Geometrie auszeichnet, liegt der effektive Durchmesser der Grundfläche des Funktionsmoduls im Bereich von 32 bis 52 mm, insbesondere im Bereich von 38 mm bis 46 mm.

Gemäß einer ganz besonders bevorzugten Ausgestaltung des Funktionsmoduls der erfindungsgemäßen Anordnung ist die Ausnehmung als Absatz mit einer Höhe ausgeführt, wobei die Höhe der Ausnehmung maximal 10 mm, insbesondere weniger als 8 mm, beträgt. Hierdurch wird es auf intelligente Art und Weise ermöglicht, eine möglichst große Leiterplatte für das Funktionsmodul vorzusehen, indem die Ausnehmungen nicht zu Lasten der Größe der Leiterplatte gehen. Insofern wird es ermöglicht, die erforderlichen elektronischen Bauteile auf der Leiterplatte unterzubringen, wobei bezüglich eines (im Stand der Technik weit verbreiteten) Gehäuses mit konstanter Höhe (also: ohne Absatz) durch die Vermeidung von mindestens zwei Anschlüssen, aufgrund des Verzichtes auf eine fliegende Verkabelung, nicht genutzte Gehäusevolumina durch die erfindungsgemäßen Ausnehmungen beansprucht werden. Dabei wird erfindungsgemäß ausgenutzt, dass durch die erfindungsgemäße Schnittstelle mit Anschlüssen, bezüglich vorbekannter Funktionsmodule mit mindestens sechs Anschlüssen (freie Verkabelung erforderlich), zwei oder mehr Anschlüsse eingespart werden können, und diese Einsparungen in Gestalt der erfindungsgemäßen Ausnehmung so abgebildet werden, dass die Ausnehmung gerade mit den Vorsprüngen des Schaltgerätes in Eingriff gestellt ist. Hierdurch wird gegenüber einer Anordnung, in der die Ausnehmungen nicht mit den Vorsprüngen des Schaltgerätes in Eingriff gestellt sind, wertvolle Einbautiefe eingespart, und zwar ohne die Größe der Leiterplatte einzuschränken, da die erfindungsgemäße Ausnehmung als Absatz ausgeführt ist. Dadurch, dass die Höhe der Ausnehmung erfindungsgemäß maximal 10 mm, insbesondere weniger als 8 mm, beträgt, wird das Volumen des Funktionsmoduls dabei nur so weit eingeschränkt, wie es erforderlich ist, um den maximalen Einbautiefengewinn zu gewinnen.

Gemäß einer weiteren Ausgestaltung des Funktionsmoduls der erfindungsgemäßen Anordnung weist das Gehäuse mindestens zwei rillenartige Vertiefungen auf, die zur optimalen Positionsfixierung mit dazu komplementären Vorsprüngen des Schaltgerätes in Eingriff zu bringen sind. Durch solche rillenartige Vertiefungen beziehungsweise die damit in Eingriff gestellten komplementären Vorsprünge des Schaltgerätes wird es auf besonders einfache und effektive Art und Weise ermöglicht, die Positionsfixierung des Funktionsmoduls an dem Schaltgerät sicherzustellen.

Gemäß einer weiteren Ausgestaltung des Funktionsmoduls der erfindungsgemäßen Anordnung ist die Ausnehmung des Gehäuses so ausgeführt, dass durch das Gehäuse ein quaderförmiger Vorsprung ausgebildet wird.

Gemäß einer weiteren Ausgestaltung des Funktionsmoduls der erfindungsgemäßen Anordnung weist dieses ein Fixiermittel, beispielsweise einen Kleber, insbesondere ein doppelseitiges Klebeband auf seinem Gehäuse auf.

Die Erfindung betrifft ferner ein Verfahren zur Montage einer erfindungsgemäßen Anordnung in einer Installationsdose, umfassend die folgenden Schritte:
- Elektrischer Anschluss des Funktionsmoduls über die Schnittstelle an eine Energieversorgungsleitung,
- Ineingriffstellen des Funktionsmoduls mit seinen Ausnehmungen mit den Vorsprüngen des Schaltgerätes,
- Gemeinsames Einsetzen und Festlegen des Funktionsmoduls und des Schaltgerätes in einer Installationsdose.

In einem ersten Schritt wird dabei das Funktionsmodul über die Schnittstelle an eine Energieversorgungsleitung angeschlossen. Dieses umfasst regelmäßig den Anschluss an den Außenleiter und gegebenfalls den Neutralleiter. Optional (sollte keine funkbasierte Ansteuerung eines Aktors vorliegen) werden über die Schnittstelle des Funktionsmoduls zudem eine oder mehrere Steuerleitungen angeschlossen.

In einem zweiten Schritt wird das Funktionsmodul mit seinen Ausnehmungen mit den Vorsprüngen des Schaltgerätes in Eingriff gestellt. Hierdurch wird nicht nur der effektiv benötigte Bauraum reduziert, sondern auch eine Vorzugslage des Funktionsmoduls mit seinem Magnetfeldsensor bezüglich des Magneten des Schaltgerätes geschaffen.

In einem dritten Schritt wird die erfindungsgemäße Anordnung, umfassend das Funktionsmodul und das Schaltgerät, gemeinsam in einer Installationsdose eingesetzt (also: aufgrund des durch die Ausnehmungen geführten Ineingriffstellens zwischen Funktionsmodul und Schaltgerät wie ein Bauteil) und dann festgelegt, beispielsweise über Spreizkrallen und/oder Schrauben.

Vorteilhaft dabei ist, dass gerade keine elektrische Steckverbindung zwischen Schaltgerät und Funktionsmodul besteht, sondern die aufgrund des durch die Ausnehmungen geführten Ineingriffstellens zwischen Funktionsmodul und Schaltgerät eine geführte, mechanische Lagerung des Funktionsmoduls an dem Schaltgerät erreicht wird. Dieses ist insbesondere im Falle der nachträglichen Montage eines Funktionsmoduls hinter ein bestehendes Schaltgerät vorteilhaft, da hierdurch die beschriebenen Vorteile erreicht werden, ohne dass ein Austausch des Schaltgerätes erforderlich wäre, was die Attraktivität für den Anwender erheblich verbessert.

Nachfolgend ist der Stand der Technik und die Erfindung unter Bezugnahme auf die beigefügten Figuren anhand diverser Ausführungsbeispiele beschrieben. Es zeigen:
- **Fig. 1:**: eine schematische Seitenansicht eines Schaltgerätes in einer flachen Installationsdose,
- **Fig. 2:**: eine schematische Seitenansicht eines Schaltgerätes in einer flachen Installationsdose mit angedeutetem gattungsgemäßem Funktionsmodul,
- **Fig. 3:**: eine schematische Seitenansicht eines Schaltgerätes in einer tiefen Installationsdose mit gattungsgemäßem Funktionsmodul, wobei das Funktionsmodul in Folge einer mechanischen Erschütterung verrutscht,
- **Fig. 4:**: eine schematische Seitenansicht eines Schaltgerätes in einer flachen Installationsdose mit einem Funktionsmodul der erfindungsgemäßen Anordnung, wobei das Gehäuse Ausnehmungen aufweist, die mit Vorsprüngen des Schaltgerätes in Eingriff gestellt sind,
- **Fig. 5:**: eine schematische, perspektivische Ansicht eines Funktionsmoduls der erfindungsgemäßen Anordnung (links) sowie eine schematische Querschnittsansicht eines solchen (rechts),
- **Fig. 6:**: eine schematische, perspektivische Ansicht eines Funktionsmoduls der erfindungsgemäßen Anordnung, wobei das Gehäuse vier rillenartige Vertiefungen aufweist, die zur optimalen Positionsfixierung mit dazu komplementären Vorsprüngen des (nicht dargestellten) Schaltgerätes in Eingriff zu bringen sind, und
- **Fig. 7:**: eine schematische, perspektivische Ansicht eines Funktionsmoduls der erfindungsgemäßen Anordnung, wobei die Ausnehmung des Gehäuses so ausgeführt ist, dass durch das Gehäuse ein quaderförmiger Vorsprung ausgebildet wird.

In den verschiedenen Figuren sind gleiche Teile stets mit den gleichen Bezugszeichen versehen und werden daher in der Regel auch jeweils nur einmal benannt beziehungsweise erwähnt.

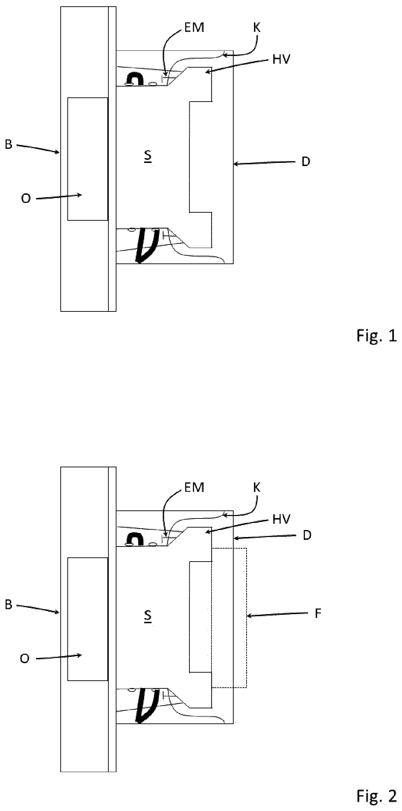

Das in Figur 1 schematisch in einer Seitenansicht dargestellte, aus dem Stand der Technik vorbekannte Schaltgerät S ist in einer flachen Installationsdose D angeordnet. Durch Betätigung eines an dem Schaltgerät S angeschlossenen Betätigungselementes B eines Oberteils O des Schaltgerätes S ist das Schaltgerät S beeinflussbar, beispielsweise zum Schalten einer Lampe.

Figur 2 zeigt eine schematische Seitenansicht eines Schaltgerätes in einer flachen Installationsdose mit angedeutetem gattungsgemäßem Funktionsmodul F einer erfindungsgemäßen Anordnung, wobei erkennbar ist, dass ein solches Funktionsmodul F aufgrund seiner Dimensionierung bezüglich der Vorsprünge HV des Schaltgerätes S wertvoller Bauraum verschenkt wird. Angedeutet ist, dass das Funktionsmodul F nicht mehr in die Installationsdose D passt, so dass praktisch die Installation eines solchen vorbekannten Funktionsmoduls F nicht durchführbar ist, obwohl dieses attraktive Funktionen, beispielsweise das Dimmen, das Schalten von Verbrauchern, das Steuern von Jalousien oder dergleichen, fernbedienbar bereitstellen würde.

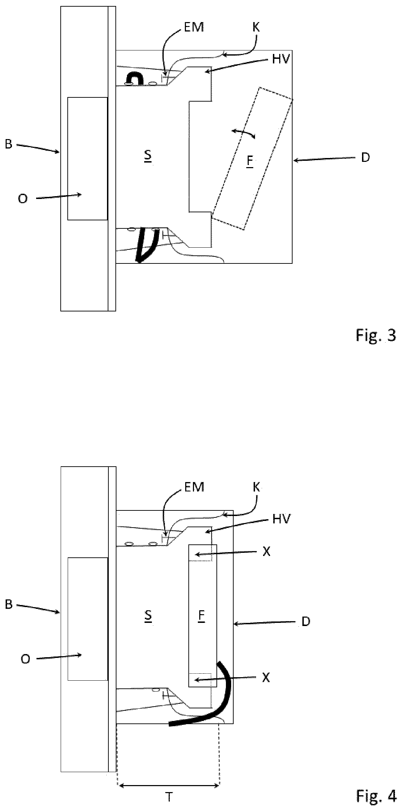

Daher werden in der Praxis solche Funktionsmodule F lediglich in sogenannten tiefen Installationsdosen D eingebaut, siehe Figur 3, die eine schematische Seitenansicht eines Schaltgerätes S in einer tiefen Installationsdose D mit Funktionsmodul F einer gattungsgemäßen Anordnung zeigt. Dabei weist das Funktionsmodul F zumindest eine Schnittstelle auf (nicht näher dargestellt), mittels welcher zumindest ein Aktor entsprechend einer Betätigung des Betätigungselements B ansteuerbar ist, wobei an dem Schaltgerät S mindestens ein Magnet M angeordnet ist, welcher bei Betätigung des Betätigungselementes B seine Position ändert. Ferner weist das Funktionsmodul F einen Sensor H zur Erfassung des Magnetfeldes auf, so dass die Änderung des Magnetfeldes bei Betätigung des Betätigungselementes B detektiert wird. Dabei weist das Funktionsmodul F eine Auswerteeinheit zur Auswertung der Magnetfeldänderung auf, die dazu eingerichtet ist, in Abhängigkeit der sensierten Magnetfeldänderung zu identifizieren, um welche Schaltgeräteart es sich bei dem Schaltgerät S handelt, welche Identifikation in die funktionsmodulseitige Ansteuerung des Aktors einfließt. Hierdurch wird es ermöglicht, die Identifikation der Schaltgeräteart durch die Auswerteeinheit vorzunehmen, so dass die Ansteuerung des jeweiligen Aktors auf korrekte Art und Weise vorgenommen wird, ohne dass ein Austausch des Schaltgerätes S, beispielsweise der Ersatz eines Schalters durch einen Taster, wie es regelmäßig zum Betrieb eines Dimmers nötig ist, erforderlich wäre. Bei einem solchen Funktionsmodul F wird die Betätigung magnetisch detektiert, ohne dass ein elektrischer Kontakt zwischen Funktionsmodul F und Schaltgerät S gegeben sein muss. Daher ist ein solches vorbekanntes Funktionsmodul F von einem grundsätzlich großen Interesse im Bereich der Gebäudeinstallationstechnik, da der Installationsaufwand überschaubar ist gegenüber Funktionsmodulen F, die über mehrere Kabel (sogenannte fliegende Verkabelung) mit dem Schaltgerät S zu verbinden sind. Problematisch jedoch bleibt der hohe Bauraumbedarf sowie der Aspekt, dass selbst relativ geringe Erschütterungen zu einem Verrutschen beziehungsweise Wackeln eines solchen vorbekannten Funktionsmoduls F führt. Dadurch wird zwischen Magnet M (regelmäßig im beziehungsweise am Oberteil O beziehungsweise Betätigungselement B des Schaltgerätes S angeordnet) und Sensor H zur Erfassung des Magnetfeldes eine Relativbewegung induziert, die zu unerwünschten Fehlbetätigungen führt, da das Funktionsmodul F solche Erschütterungen, die zu einem Verrutschen des Funktionsmoduls F führen, physikalisch nicht unterscheiden kann von einer tatsächlichen Betätigung des Schaltgerätes S und damit des angeschlossenen Verbrauchers.

Zur Lösung des Bauraum- und des Detektionsproblems ist in Figur 4 ein Funktionsmodul F der erfindungsgemäßen Anordnung gezeigt, welches Funktionsmodul F ein Gehäuse G aufweist, welches eine Schnittstelle mit (beispielsweise maximal vier) Anschlüssen aufweist. Die optionale Minimierung der Anzahl der Anschlüsse auf vier wird im Vergleich zu anderen ohne Magnetsensor ausgestatteten Funktionsmodulen F erst möglich, da Anschlüsse für die Verbindung zwischen Funktionsmodul F und Schaltgerät S entfallen. Diesen Aspekt ausspielend, weist das erfindungsgemäße Gehäuse G mindestens eine Ausnehmung X auf, die mit den Vorsprüngen HV des Schaltgerätes S in Eingriff gestellt ist. Solche Vorsprünge HV erstrecken sich regelmäßig in Richtung des Bodens der Installatiosndose D und dienen als Haltevorrichtung, in die Schraubdome eingesetzt sind, um die mittels Einstellmitteln EM verstellbaren Spreizkrallen zur Festlegung des Schaltgerätes S an der Installationsdose D sicherzustellen. Durch die mögliche Reduktion der Anzahl der Anschlüsse von mindestens sechs (bei Funktionsmodulen F, die elektrisch mit dem Schaltgerät S verbunden werden) auf vier (beispielhafte erfindungsgemäße Ausführungsform) wird es erreicht, dass das erfindungsgemäße Gehäuse G eine, wie in Figur 4 dargestellt regelmäßig auch zwei, Ausnehmungen X aufweisen kann, da das benötigte Volumen für die wegfallenden Anschlüsse entfällt. Insofern wird das entfallene Volumen geschickt zur Schaffung mindestens einer Ausnehmung X im Gehäuse G genutzt. Durch das vorteilhafte erfindungsgemäße Ineingriffstellen der mindestens einen Ausnehmung X mit den Vorsprüngen HV des Schaltgerätes S wird es erreicht, dass die effektive Einbautiefe T im Vergleich zu vorbekannten Funktionsmodulen F signifikant verringert wird. Gleichzeitig wird hierdurch eine Positionsfixierung erreicht, die die Stabilität der Detektion von tatsächlichen Betätigungen des Schaltgerätes S gegenüber Erschütterungen, die zu einem Bewegen des Funktionsmoduls F führen, wirksam verbessert. Ferner erlaubt das definierte Ineingriffstellen der mindestens einen Ausnehmung X mit den Vorsprüngen HV des Schaltgerätes S eine Vorzugslage zu schaffen, die sich positiv auf das Signal-Rausch-Verhältnis des Sensors H beziehungsweise für die Auswertung der Magnetfeldänderung bezüglich des durch den Magneten verursachten Magnetfeldes durch die Auswerteeinheit auswirkt. Insofern werden durch das erfindungsgemäße Ineingriffstellen der mindestens einen Ausnehmung X mit den Vorsprüngen HV eine Vielzahl unterschiedlicher Vorteile gleichzeitig erreicht: Die Minimierung des Bauraumbedarfs, die Verbesserung der Detektionsstabilität durch eine Positionsfixierung und das Schaffen einer Vorzugslage zur Optimierung des Signal-Rausch-Verhältnisses. Damit wird das erfindungsgemäße Funktionsmodul für viele Anwender, insbesondere auch im Altbau, in dem lediglich flache Installationsdosen verbaut werden, interessant, was durch vorbekannte, gattungsgemäße Funktionsmodule F gerade erreicht wird.

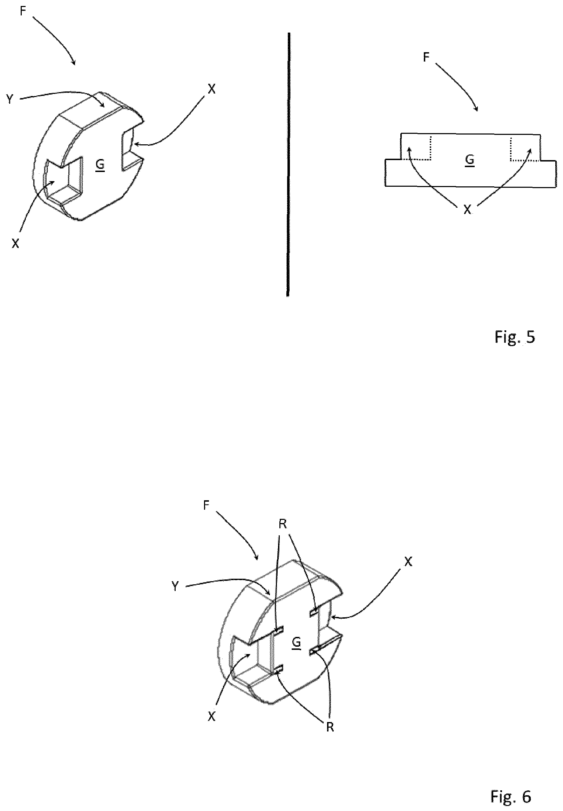

Figur 5 zeigt eine schematische, perspektivische Ansicht eines Funktionsmoduls F der erfindungsgemäßen Anordnung (links) sowie eine schematische Querschnittsansicht eines solchen (rechts). Erkennbar ist, dass das in einer besonders bevorzugten Ausführungsform dargestellte Funktionsmodul F ein Gehäuse G aufweist, das zwei Ausnehmungen X aufweist. Diese sind so ausgebildet, dass sie mit Vorsprüngen HV (regelmäßig zwei Haltevorrichtungen für Schraubdome zur Einstellung der Spreizkrallen K mittels Einstellmitteln EM) des Schaltgerätes S (nicht in Figur 5 dargestellt) in Eingriff zu bringen sind. Dabei macht die mindestens eine Ausnehmung X bezüglich der Grundfläche des Funktionsmoduls F in einer Draufsicht weniger als 50%, insb. weniger als 30% der Grundfläche aus. Hierdurch wird das Volumen des Funktionsmoduls F auf - hinsichtlich der effektiven Einbautiefe T - besonders effektive Weise verringert. Zur optimalen Einbringung und Ausnutzung des Volumens einer Installatiosndose D liegt der Krümmungsradius der Grundfläche des Funktionsmoduls F im Bereich von 18 bis 27 mm, der effektive Durchmesser der Grundfläche des Funktionsmoduls F im Bereich von 32 bis 52 mm, insbesondere im Bereich von 38 mm bis 46 mm. Bezüglich des Vorsehens einer bezüglich der Grundfläche nicht durch die Ausnehmungen X eingeschränkten/verkleinerten Leiterplatte sind die Ausnehmungen X als Absatz mit einer Höhe ausgeführt, wobei die Höhe der Ausnehmung maximal 10 mm, insbesondere weniger als 8 mm, beträgt. Hierdurch wird es ermöglicht, eine möglichst große (durch die Ausnehmung(en) nicht beeinträchtigte Leiterplattendimensionierung vorzusehen. Bauteile mit einer höheren Höhe (wie beispielsweise Anschlüsse in Gestalt einer Schraub- oder Steckklemme) sind somit in einem Bereich größerer Höhe (außerhalb der Ausnehmung(en) X) anzuordnen.

Figur 6 zeigt eine schematische, perspektivische Ansicht eines Funktionsmoduls F der erfindungsgemäßen Anordnung. Dabei umfasst das Gehäuse G vier rillenartige Vertiefungen R, die zur optimalen Positionsfixierung mit dazu komplementären Vorsprüngen des (nicht dargestellten) Schaltgerätes S in Eingriff zu bringen sind. Schaltgeräte S bestimmter Hersteller weisen derartige Vorsprünge auf, so dass durch das erfindungsgemäße Vorsehen von rillenartigen Vertiefungen R im Gehäuse G des Funktionsmoduls F die Positionsfixierung noch weiter verbessert werden kann, so dass eine optimale formschlüssige Verbindung (ohne Spiel) zwischen Funktionsmodul F und Schaltgerät S erreicht werden kann.

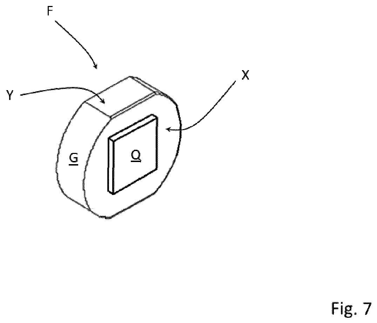

Figur 7 betrifft eine schematische, perspektivische Ansicht eines Funktionsmoduls F der erfindungsgemäßen Anordnung, wobei die Ausnehmung des Gehäuses G so ausgeführt ist, dass durch das Gehäuse G ein quaderförmiger Vorsprung Q ausgebildet wird.

Die Erfindung ist anhand von Ausführungsbeispielen beschrieben. Ohne den Umfang der geltenden Ansprüche zu verlassen, ergeben sich für einen Fachmann zahlreiche weitere Möglichkeiten, diese umzusetzen, ohne dass dieses im Rahmen dieser Ausführungen im Einzelnen erläutert werden müsste.

### Bezugszeichenliste

- A: Aufsatz
- B: Betätigungselement
- D: Installationsdose
- EM: Einstellmittel
- F: Funktionsmodul
- G: Gehäuse
- H: Sensor
- HV: Vorsprünge
- K: Spreizkralle
- M: Magnet
- O: Oberteil
- Q: quaderförmiger Vorsprung
- R: rillenartige Vertiefung
- S: Schaltgerät
- T: Einbautiefe
- X: Ausnehmung
- Y: abgeflachte Seite

## Patentansprüche

1. Anordnung umfassend ein Funktionsmodul (F) zum Einbau in eine Installationsdose und ein manuell zu betätigendes Schaltgerät (S) der Gebäudeinstallationstechnik, welches Funktionsmodul (F) durch die Betätigung eines an dem Schaltgerät (S) angeschlossenen Betätigungselementes (B) eines Oberteils (O) des Schaltgerätes (S) beeinflussbar ist, wobei das Funktionsmodul (F) zumindest eine Schnittstelle aufweist, mittels welcher zumindest ein Aktor entsprechend einer Betätigung des Betätigungselements (B) ansteuerbar ist, wobei an dem Schaltgerät (S) mindestens ein Magnet (M) angeordnet ist, welcher bei Betätigung des Betätigungselementes (B) seine Position ändert, und dass das Funktionsmodul (F) einen Sensor zur Erfassung des Magnetfeldes aufweist, so dass die Änderung des Magnetfeldes bei Betätigung des Betätigungselementes (B) detektiert wird, wobei das Funktionsmodul (F) eine Auswerteeinheit zur Auswertung der Magnetfeldänderung aufweist, die dazu eingerichtet ist, in Abhängigkeit der sensierten Magnetfeldänderung zu identifizieren, um welche Schaltgeräteart es sich bei dem Schaltgerät (S) handelt, welche Identifikation in die funktionsmodulseitige Ansteuerung des Aktors einfließt, **dadurch gekennzeichnet, dass** das Funktionsmodul (F) ein Gehäuse (G) aufweist, welches eine Schnittstelle mit Anschlüssen aufweist, wobei das Gehäuse (G) mindestens eine Ausnehmung (X) aufweist, die mit Vorsprüngen (HV) des Schaltgerätes (S) in Eingriff gestellt ist, so dass die effektive Einbautiefe (T) des Funktionsmoduls in der Installationsdose hinter dem Schaltgerät (S) verringert und das Funktionsmodul (F) positionsfixiert wird.

2. Anordnung nach Anspruch 1, wobei die mindestens eine Ausnehmung (X) mindestens teilweise komplementär zu den Vorsprüngen (HV) des Schaltgerätes (S) ist.

3. Anordnung nach einem der Ansprüche 1 bis 2, wobei das Funktionsmodul abgeflachte Seiten (Y) aufweist.

4. Anordnung nach einem der Ansprüche 1 bis 3, wobei die mindestens eine Ausnehmung (X) bezüglich der Grundfläche des Funktionsmoduls (F) in einer Draufsicht weniger als 50 %, insb. weniger als 30 % der Grundfläche ausmacht.

5. Anordnung nach einem der Ansprüche 1 bis 4, wobei der Krümmungsradius der Grundfläche des Funktionsmoduls (F) im Bereich von 18 bis 27 mm liegt.

6. Anordnung nach einem der Ansprüche 1 bis 5, wobei der effektive Durchmesser der Grundfläche des Funktionsmoduls (F) im Bereich von 32 bis 52 mm liegt.

7. Anordnung nach einem der Ansprüche 1 bis 6, wobei die Ausnehmung (X) als Absatz mit einer Höhe ausgeführt ist, wobei die Höhe der Ausnehmung maximal 10 mm beträgt.

8. Anordnung nach einem der Ansprüche 1 bis 7, wobei das Gehäuse (G) mindestens zwei rillenartige Vertiefungen (R) aufweist, die zur optimalen Positionsfixierung mit dazu komplementären Vorsprüngen (HV) des Schaltgerätes (S) in Eingriff zu bringen sind.

9. Anordnung nach einem der Ansprüche 1 bis 8, wobei die Ausnehmung (X) des Gehäuses (G) so ausgeführt ist, dass durch das Gehäuse (G) ein quaderförmiger Vorsprung (Q) ausgebildet wird.

10. Verfahren zur Montage einer Anordnung gemäß einem der Ansprüche 1 bis 9, umfassend die folgenden Schritte:
- Elektrischer Anschluss des Funktionsmoduls (F) über die Schnittstelle an eine Energieversorgungsleitung,
- Ineingriffstellen des Funktionsmoduls (F) mit seinen Ausnehmungen (X) mit den Vorsprüngen des Schaltgerätes (S),
- Gemeinsames Einsetzen und Festlegen des Funktionsmoduls (F) und des Schaltgerätes (S) in einer Installationsdose (D).

## Claims

1. An assembly comprising a functional module (F) for installation in a junction box and a manually operated switching device (S) for building installation technology, said functional module (F) being controllable by the actuation of an actuating element (B) of an upper part (O) of the switching device (S), whereby the functional module (F) comprises at least one interface by means of which at least one actuator can be controlled in accordance with the actuation of the actuating element (B), whereby at least one magnet (M) is arranged on the switching device (S), changing its position upon actuation of the actuating element (B), and in that the functional module (F) comprises a sensor for detecting the magnetic field, so that the change in the magnetic field upon actuation of the actuating element (B) is detected, wherein the functional module (F) comprises an evaluation unit for evaluating the change in the magnetic field, which evaluation unit is configured to identify, on the basis of the sensed change in the magnetic field, the type of switching device (S), which identification is incorporated into the function module's control of the actuator, **characterised in that** the functional module (F) comprises a housing (G) providing an interface with terminals, wherein the housing (G) comprises at least one recess (X) which engages with projections (HV) of the switching device (S), so that the effective installation depth (T) of the function module within the installation box behind the switching device (S) is reduced and the function module (F) is fixed in position.

2. An assembly in accordance with claim 1, wherein the at least one recess (X) is at least partially complementary to the projections (HV) of the switching device (S).

3. An assembly according to any one of claims 1 to 2, wherein the functional module has flattened sides (Y).

4. An assembly according to any one of claims 1 to 3, wherein the at least one recess (X) accounts for less than 50 per cent, in particular less than 30 per cent, of the base area of the functional module (F) as viewed from above.

5. An assembly according to any one of claims 1 to 4, wherein the radius of curvature of the base surface of the functional module (F) is in the range of 18 to 27 mm.

6. An assembly according to any one of claims 1 to 5, wherein the effective diameter of the base surface of the functional module (F) is in the range of 32 to 52 mm.

7. An assembly according to any one of claims 1 to 6, wherein the recess (X) is formed as a step having a height, the height of the recess being no more than 10 mm.

8. An assembly according to any one of claims 1 to 7, wherein the housing (G) comprises at least two groove-like recesses (R) which are to be engaged with complementary projections (HV) on the switching device (S) to ensure optimal fixing in position.

9. An assembly according to any one of claims 1 to 8, wherein the recess (X) in the housing (G) is designed such that a cuboid projection (Q) is formed through the housing (G).

10. A method of installing an assembly according to any one of claims 1 to 9, comprising the following steps:
- Electrical connection of the function module (F) to a power supply line via the interface,
- Interlocking between the recesses (X) of the functional module (F) and the projections of the switching device (S),
- Joint installation and fixing of the functional module (F) and the switchgear (S) in an installation box (D).

## Revendications

1. Dispositif comprenant un module fonctionnel (F) destiné à être monté dans une prise d'installation et un appareil de commutation (S) à commande manuelle utilisé dans le domaine des installations techniques du bâtiment, lequel module fonctionnel (F) peut être commandé par l'actionnement d'un élément d'actionnement (B) d'une partie supérieure (O) de l'appareil de commutation (S), le module fonctionnel (F) comportant au moins une interface au moyen de laquelle au moins un actionneur peut être commandé en fonction de l'actionnement de l'élément d'actionnement (B), au moins un aimant (M) étant disposé sur l'appareil de commutation (S), lequel change de position lors de l'actionnement de l'élément d'actionnement (B), et en ce que le module fonctionnel (F) comporte un capteur destiné à détecter le champ magnétique, de sorte que la variation du champ magnétique lors de l'actionnement de l'élément d'actionnement (B) soit détectée, le module fonctionnel (F) comportant une unité d'évaluation destinée à analyser la variation du champ magnétique, laquelle est agencée pour identifier, en fonction de la variation du champ magnétique détectée, le type de dispositif de commutation (S), cette identification étant prise en compte dans la commande de l'actionneur par le module fonctionnel, **caractérisé en ce que** le module fonctionnel (F) comporte un boîtier (G) muni d'une interface avec des raccordements, le boîtier (G) comportant au moins un évidement (X) qui s'engage avec des saillies (HV) de l'appareil de commutation (S), de sorte que la profondeur d'encastrement effective (T) du module fonctionnel dans la prise d'installation derrière l'appareil de commutation (S) est réduite et que le module fonctionnel (F) est immobilisé en position.

2. Dispositif selon la revendication 1, dans lequel ledit au moins un évidement (X) est au moins partiellement complémentaire des saillies (HV) de l'appareil de commutation (S).

3. Dispositif selon l'une quelconque des revendications 1 à 2, dans lequel le module fonctionnel présente des côtés aplatis (Y).

4. Dispositif selon l'une quelconque des revendications 1 à 3, dans lequel le ou les évidements (X) représentent, par rapport à la surface de base du module fonctionnel (F) vue en plan, moins de 50 %, et notamment moins de 30 %, de ladite surface de base.

5. Dispositif selon l'une quelconque des revendications 1 à 4, dans lequel le rayon de courbure de la base du module fonctionnel (F) est compris entre 18 et 27 mm.

6. Dispositif selon l'une quelconque des revendications 1 à 5, dans lequel le diamètre effectif de la base du module fonctionnel (F) est compris entre 32 et 52 mm.

7. Dispositif selon l'une quelconque des revendications 1 à 6, dans lequel l'évidement (X) est réalisé sous la forme d'un épaulement d'une certaine hauteur, la hauteur de l'évidement étant au maximum de 10 mm.

8. Dispositif selon l'une quelconque des revendications 1 à 7, dans lequel le boîtier (G) comporte au moins deux rainures (R) destinées à s'engager avec des saillies (HV) complémentaires de l'appareil de commutation (S) afin d'assurer un positionnement optimal.

9. Dispositif selon l'une quelconque des revendications 1 à 8, dans lequel l'évidement (X) du boîtier (G) est conçu de telle sorte qu'une saillie parallélépipédique (Q) soit formée dans le boîtier (G).

10. Procédé de montage d'un dispositif selon l'une quelconque des revendications 1 à 9, comprenant les étapes suivantes:
- Raccordement électrique du module fonctionnel (F) à une ligne d'alimentation électrique via l'interface,
- Mise en prise des évidements (X) du module fonctionnel (F) avec les saillies de l'appareil de commutation (S),
- Insertion et fixation conjointes du module fonctionnel (F) et de l'appareil de commutation (S) dans une prise de courant (D).
